# FASCICULE DE BREVET EUROPEEN

(11) **EP 2 867 385 B1**
(45) Date de publication et mention de la délivrance du brevet: **19.10.2016**
(21) Numéro de dépôt: 13731727.7
(22) Date de dépôt: 19.06.2013
(51) Int. Cl.: C23C 14/02, C23C 14/06, C23C 14/54, C23C 16/02, C23C 16/26, C23C 28/00

(54) **PROCÉDÉ DE DÉPOSITION D'UN REVÊTEMENT DÉCORATIF ET DE PROTECTION**
VERFAHREN ZUR ABSCHEIDUNG EINER DEKORATIVEN UND SCHÜTZENDEN BESCHICHTUNG
METHOD FOR DEPOSITING A DECORATIVE AND PROTECTIVE COATING

(30) Priorité: 28.06.2012 CH 9132012; 10.10.2012 CH 19212012
(43) Date de publication de la demande: 06.05.2015
(73) Titulaire: L.A.C. SARL-Laboratory for Advanced Coatings Serge Bourquard, 1228 Plan les Ouates (CH)
(72) Inventeur: BOURQUARD, Serge, CH-1231 Conches (CH)
(74) Mandataire: P&TS SA (AG, Ltd.)
(86) Numéro de dépôt international: PCT/EP2013/062782
(87) Numéro de publication internationale: WO 2014/001178

(56) Documents cités:
- EP-A1- 0 130 754
- EP-A1- 1 116 799
- EP-A2- 1 905 863
- US-A- 5 989 397
- US-A1- 2002 136 895
- DONNET C ET AL: "Diamond-like carbon-based functionally gradient coatings for space tribology", SURFACE AND COATINGS TECHNOLOGY, ELSEVIER, AMSTERDAM, NL, vol. 120-121, 1 novembre 1999 (1999-11-01) , pages 548-554, XP027328946, ISSN: 0257-8972 [extrait le 1999-11-01]

## Description

### Domaine technique

La présente invention concerne un procédé de déposition d'un revêtement décoratif présentant une surface d'une couleur déterminée, par exemple noire ou grise, obtenue par un procédé de dépôt physique sous vide en phase vapeur (PVD) tel que la pulvérisation cathodique. Le procédé de l'invention se prête particulièrement à la production d'éléments de montre, de bijoux, de lunettes ou d'autres objets de décoration.

### Etat de la technique

L'industrie du domaine décoratif, par exemple l'horlogerie, est à la recherche de nouvelles solutions en termes de couleurs et l'apparence. Les articles horlogers de couleur blanc, tels que les cadrans, sont souvent obtenus par l'application de nacres et de l'émail.

Les techniques de dépôt physique sous vide en phase vapeur (PVD), par exemple la pulvérisation cathodique, permettent d'obtenir des couches avec une apparence et des couleurs qui ne peuvent pas être réalisées avec des techniques de peinture ou émaillage conventionnelles. Ces couches sont également plus fines et présentent une grande durabilité, ce qui en permet l'emploi dans des éléments de petites tailles ou sujets à l'usure.

On connaît des procédés permettant l'obtention de couches minces de couleur noir de type TiALN par PVD. Avec ces procédés on obtient un éclat de type métallique et une surface compacte mais il est difficile d'atteindre une couleur absolument noire. Par ailleurs, les couches de type TiAlN peuvent être attaquées par des agents chimiques agressifs, ce qui limite la résistance à la corrosion et la tenue au porter des objets ainsi réalisés.

On connaît également des procédés de déposition de couches noires de type DLC (Diamond Like Carbon), par exemple par des sources de carbone de type arc cathodique. Les couches ainsi obtenues exhibent des valeurs excellentes de dureté et résistance, mais présentent souvent une surface 'laiteuse' et une couleur tendant vers le gris qui ne parvient pas au noir absolu.

US5989397 décrit une installation dans laquelle une structure avec des couches Ti, TiN, TiNC et DLC est obtenue par l'utilisation de deux sources, une source magnétron avec cible en Titane, en atmosphère inerte ou réactive, pour les couches Ti, TiN, TiNC ; et une source laser pulsé dans des condition de vide poussé pour les couches DLC.

EP0130754, US2002136895, EP1905863 décrivent la production de couches DLC par des sources magnétron à cible de carbone.

EP1116799 divulgue des couches noires résistantes aux empreintes digitales en carbonitrures métalliques.

XP027328946 = *"*Diamond-like carbon-based functionally gradient coatings for space tribology" by C. Donnet et al. publié en "Surface and Coatings Technology" 120-121 (1991) pp 548-554, divulgue la production de couches DLC en un réacteur à plasma par la technologie PACVD (Plasma Assisted Chemical Vapour Deposition).

### Bref résumé de l'invention

Un but de la présente invention est de proposer un procédé de déposition d'une couche décorative noire exempt des limitations des procédés connus.

Selon l'invention, ces buts sont atteints notamment au moyen de l'objet des revendications annexées.

### Brève description des figures

Des exemples de mise en oeuvre de l'invention sont indiqués dans la description illustrée par les figures annexées dans lesquelles :
- La Figure 1 représente une structure possible pour le revêtement produit par le procédé de l'invention.
- La Fig. 2 illustre un profil de pression partiel de gaz réactif selon un aspect de l'invention.

### Exemple(s) de mode de réalisation de l'invention

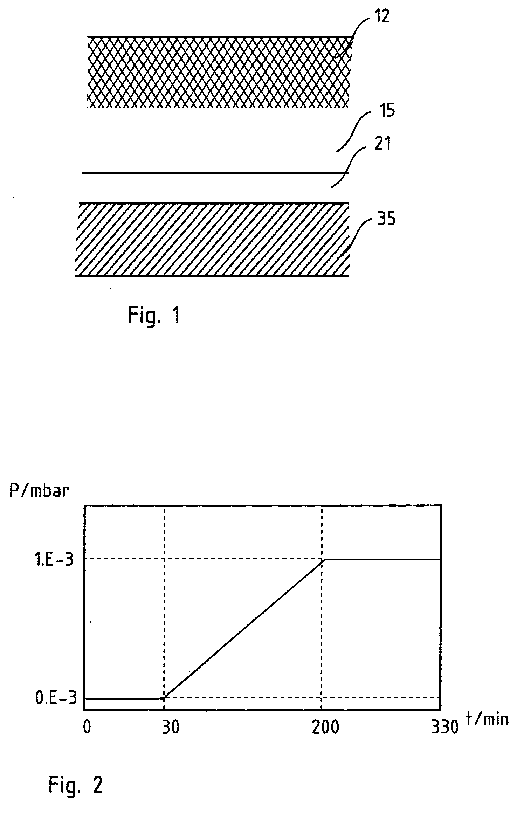

Avec référence aux figures 1 et 2, Le procédé de l'invention a pour résultat un revêtement décoratif et de protection sur un substrat 35 qui peut être composé par tout matériau sur lequel on souhaite déposer une couche décorative. Parmi les matériaux possibles on cite, à titre d'exemple non exhaustifs, des pièces en acier, laiton, maillechort, or, ou alliages d'or, titane, saphir ou verre.

La pièce 35 peut être, par exemple un élément d'horlogerie ou d'habillage de montre au quel on souhaite donner une surface noire brillante et compacte. On peut par exemple exploiter le procédé inventif sur une boite, une lunette, un fond, une carrure, une aiguille, un cadran, un index, une masse oscillante, une platine, ou un élément d'un mouvement d'horlogerie, ainsi qu'un fermoir ou un maillon de bracelet. On peut également revêtir avec le procédé de l'invention aussi des éléments décoratifs pour des lunettes, ou des instruments d'écriture, ou des accessoires métalliques pour la maroquinerie, ou encore des vis ou des éléments de fixation.

La sous-couche d'accrochage 21, par exemple une couche de chrome, titane, tantale, tungstène, ou tout autre matériau idoine. De préférence la sous-couche d'accrochage est réalisée en un matériau qui forme des carbures et/ou des carbonitrures. Elle est déposée par pulvérisation cathodique à partir d'une source de pulvérisation du même matériau dans un système de déposition physique en phase vapeur (PVD). De manière connue, la source est alimentée en radio fréquence (RF-Sputtering) et l'enceinte de pulvérisation est remplie avec une atmosphère de gaz inerte à faible pression, par exemple argon, néon, krypton ou xénon à une pression entre 2 x 10⁻³ mbar et 5 x 10⁻³ mbar jusqu'à l'obtention d'une sous-couche 21 de l'épaisseur souhaité, par exemple entre 200 nm et 500 nm.

Sur la sous-couche 21 est superposé un empilement 15 de couches successives avec une teneur en carbone progressivement croissante qui est obtenu en ajoutant, à l'atmosphère de l'enceinte de pulvérisation, une fraction progressivement croissante d'un hydrocarbure réactif. Des essais expérimentaux ont démontré que la proportion de carbone dans l'empilement 15 peut passer avec continuité d'une valeur proche de zéro, lorsque l'atmosphère ne contient que du gaz inerte, par exemple de l'argon, jusqu'à une valeur sensiblement proche de 100% en présence d'une pression partielle d'hydrocarbure entre 20 et 30% approximativement. Au dessus de cette concentration de saturation on observe une réduction de la vitesse de déposition. On peut également déterminer si le système a atteint la concentration de saturation en observant les paramètres électriques de la cible magnétron, la concentration de saturation est indiquée par une diminution (en valeur absolu) de la tension d'auto-polarisation de la cible.

Sans vouloir être limités par la théorie, on pense que, à des concentrations proches de 20-30%, la cible magnétron est couverte d'une couche extrêmement mince de carbone en sorte que le chrome, ou le métal qui la compose, n'est pas pulvérisé. Des analyses effectuées sur les couches déposées selon le procédé inventif ont confirmé que, lorsque la concentration de gaz réactif atteint le niveau de saturation de la cible, on dépose une couche composée essentiellement de carbone avec un contenu en chrome négligeable. Il y a toutefois un résidu d'hydrogène lié à la présence de ce gaz dans le gaz réactif. En diminuant la pression partielle de gaz organique afin d'être sous le seuil de saturation de la cible, on peut obtenir en couche finale 12 des carbures, nitrures ou carbonitrures d'aspect gris plus ou moins foncé selon le degré de sous-alimentation de la cible en gaz réactif.

La plupart des gaz organiques réactifs sont utilisables dans le procédé de l'invention. Des essais avec l'éthylène ont donné des couches de couleur noir intense et brillant, avec une remarquable stabilité et une excellente résistance à la corrosion. L'invention peut par exemple utiliser comme gaz réactif l'acétylène, le méthane, ou des mélanges de gaz réactifs. L'ajout d'une faible quantité d'azote ou d'un gaz contenant de l'azote, par exemple de l'ammoniac ou un composé organique azoté, peut aussi améliorer la dureté du revêtement par la formation de nitrures et carbonitrures dans l'empilement de couches 15 et jusque dans la couche 12.

La vitesse de déposition dans le procédé de l'invention est préférablement inférieure à 1000 nm / heure, plus préférablement entre 400 et 800 nm / heure. Ces vitesses relativement modérées sont obtenues avec une basse pression de gaz dans l'enceinte, ce qui correspond à un bombardement énergétique de la cible et de la pièce sur laquelle le revêtement est déposé, et donne lieu à des couches particulièrement denses avec une dureté aux alentours de 1500 Vickers. L'invention ne se limite pas à l'utilisation d'une seule cible. L'utilisation en parallèle ou en séquence de plusieurs cibles constituées du même matériau (par exemple Cr) ou de matériaux distincts permet de varier la composition et l'alternance des différentes couches qui composent le revêtement pour adapter ses propriétés physiques ou chimiques aux applications les plus variées.

Comme on l'a vu plus haut, et comme indiqué par la figure 2, la pression partielle de gaz réactif augmente jusqu'au niveau de saturation de la cible qui est soit prédéterminé par une calibration préalable, soit détecté par le monitorage de la vitesse de croissance du film, soit déduit des paramètres électriques de la source magnétron. Une fois atteint ce niveau, on dépose une couche 12 de carbone amorphe essentiellement à 100%, obtenue en maintenant la pression partielle de gaz réactif à la valeur de saturation, ou très prés de la valeur de saturation. La couche ainsi déposée présente alors une couleur noire intense, et un aspect brillant très décoratif. Les valeurs numériques de pression partielle et de temps indiqués sur la figure 1 sont fournies à titre d'exemple et ne doivent pas être considérées comme des limitations de l'invention.

En polarisant négativement le substrat au moyen d'une alimentation RF ou DC-pulsée, on provoque le bombardement de la surface du substrat par un flux énergétique de ions positifs (typiquement des ions d'argon, mais pas exclusivement). Il en résulte une élévation marquée de la température du substrat qui peut être établie à plus de 350 degrés Celsius selon la puissance délivrée par l'alimentation électrique. Une augmentation similaire de la température peut aussi être obtenue par chauffage infrarouge du substrat. La montée en température du substrat a pour conséquence l'augmentation de la mobilité des atomes en surface durant la phase de croissance du dépôt solide. Il en résulte une structure très dense de carbone en grains allongés à très faible teneur en hydrogène où dominent les liaisons de type Sp3 (liaisons de type diamant) favorables à la dureté du revêtement. Les couches déposées avec cette polarisation peuvent atteindre des duretés supérieures à 2500 Vickers. De même que noté plus haut, ici aussi la sous-alimentation de la cible en gaz réactif permet d'obtenir des couches de couleur grise mais d'une dureté supérieure à celle obtenue sans la montée en température du substrat.

Selon un aspect important de l'invention, la déposition d'un empilement de couches avec un contenu progressivement croissant en carbone permet d'obtenir des revêtements particulièrement stables et des excellentes adhésions au substrat. On interprète cet effet favorable comme du au fait que le degré de stress interne des couches déposées augmente progressivement, le long de l'empilement, ensemble avec la teneur en carbone. De cette façon, les stress internes sont distribués à l'intérieur du revêtement et non concentrés à ses interfaces. L'épaisseur particulière entre 200 et 500 nm de la sous-couche d'accrochage 21 participe à ce principe de distribution des stress internes.

Au dessus de la couche 12 on peut déposer des couches de protection et de finition non représentés, par exemple des couches anti-tâche. Selon un aspect optionnel de l'invention, par exemple, on peut superposer au revêtement de la Fig. 1 une couche anti-tâche contenant des groupes C-F en ajoutant une proportion de gaz fluorocarbure à l'atmosphère réactive.

Le procédé de la présente invention comporte entre-autres l'avantage de permettre la déposition de la sous-couche d'accrochage 21, de l'empilement de couches 15, et de la couche de carbone amorphe 12 par une même source de pulvérisation de type magnétron. On peut notamment utiliser un magnétron avec une cible métallique en chrome, titane, tantale, tungstène, ou tout autre matériau idoine, pour produire, en atmosphère inerte, une couche d'accrochage de cette substance et ajouter ensuite un gaz hydrocarbure pour générer un gradient de concentration de carbone. L'invention se base notamment sur l'observation, faite par l'inventeur, qu'il est possible d'obtenir des couches essentiellement de carbone amorphe avec des excellentes caractéristiques esthétiques et d'adhésion, agissant sur la concentration de gaz réactif, bien que la source magnétron comporte une cible d'un matériau différent du carbone.

## Revendications

1. Procédé de déposition physique en phase vapeur pour déposer un revêtement de couleur noire intense décoratif et/ou de protection sur un substrat (35), comprenant :
• déposition par pulvérisation d'une sous-couche d'accrochage (21) en atmosphère inerte par une source ou par plusieurs sources de type magnétron,
• ajout progressif d'un gaz hydrocarbure à l'atmosphère inerte selon un profil de concentration déterminé, en maintenant la source ou les sources magnétron actives, de façon à obtenir un empilement de couches (15) avec une proportion progressivement croissante de carbone au dessus de la sous-couche d'accrochage (21),
• montée de la pression partielle de gaz réactif jusqu'à un niveau de saturation de la cible de la source ou des sources, niveau auquel on dépose une couche (12) de carbone amorphe sur le substrat (35).

2. Procédé selon la revendication précédente dans lequel la même source magnétron est utilisée pour déposer la sous-couche d'accrochage, l'empilement de couches avec une proportion progressivement croissante de carbone, et la couche de carbone amorphe.

3. Procédé selon la revendication précédente, dans lequel la source magnétron a une cible d'un matériau différent du carbone.

4. Procédé selon l'une des revendications précédentes, comprenant le maintien de la pression partielle au niveau de saturation ou près du niveau de saturation, jusqu'à l'obtention d'une épaisseur de revêtement souhaité.

5. Procédé selon l'une des revendications précédentes, dans lequel le gaz hydrocarbure est de l'éthylène, ou de l'acétylène, ou du méthane ou un mélange de ces gaz.

6. Procédé selon l'une des revendications précédentes, dans lequel la sous-couche d'accrochage (21) est une couche de chrome, titane, tantale ou tungstène.

7. Procédé selon l'une des revendications précédentes, dans lequel l'épaisseur de la sous-couche d'accrochage (21) est comprise entre 200 et 500 nm.

8. Le procédé de l'une des revendications précédentes, dans lequel les vitesses de déposition dudit empilement de couches (15) et/ou de ladite couche de carbone (12) sont comprises entre 400 et 800 nm / heure.

9. Procédé selon l'une des revendications précédentes, comprenant l'application d'une polarisation négative RF ou DC-pulsée sur le substrat.

10. Procédé selon l'une des revendications précédentes, dans lequel la déposition est une pulvérisation RF.

11. Procédé selon l'une des revendications précédentes, comprenant une étape de détection du niveau de saturation par le monitorage de la vitesse d'accroissement de la couche déposée, ou par l'observation des paramètres électriques de la source ou des sources magnétron.

12. Application du procédé de la revendication 1 précédente, dans laquelle le substrat (35) est une pièce d'horlogerie, ou un élément de mouvement ou d'habillage de montre, ou un article de maroquinerie, de lunetterie, ou de décoration.

## Patentansprüche

1. Verfahren zur physikalischen Abscheidung in Gasphase um eine dekorative und/oder schützende Beschichtung einer tief schwarzen Farbe auf einem Substrat aufzutragen, aufweisend:
• Abscheidung durch Kathodenzerstäuben einer Haftunterschicht (21) in einer inerten Atmosphäre durch eine Quelle oder mehrere Quellen eines Magnetrontyps,
• Progressives Hinzufügen von Kohlenwasserstoff in der inerten Atmosphäre nach einem bestimmten Konzentrationsprofil, während die Magnetronquelle oder -quellen aktiv gehalten werden, so dass eine Überlagerung von Schichten (15) mit progressiv zunehmenden Anteil an Kohlenstoff über der Haftunterschicht (21) erhalten wird,
• Erhöhen eines Teildrucks eines reaktiven Gases auf ein Niveau der Sättigung des Targets der Quelle oder Quellen, ein Niveau auf dem eine Schicht (12) von amorphen Kohlenstoff auf dem Substrat (35) aufgetragen wird.

2. Verfahren nach dem vorigen Anspruch, wobei die gleiche Magnetronquelle für das Auftragen der Haftunterschicht, der Überlagerung von Schichten mit einem progressif ansteigenden Anteil an Kohlenstoff und der Schicht des amorphen Kohlenstoffs verwendet wird.

3. Verfahren nach dem vorigen Anspruch, wobei die Magnetronquelle ein Target aus einem Material aufweist, das sich von Kohlenstoff unterscheidet.

4. Verfahren nach einem der vorigen Ansprüche, aufweisend Behalten des Teildrucks an oder nahe dem Sättigungsniveau, bis zu dem Erreichen der gewünschten Beschichtungsdicke.

5. Verfahren nach einem der vorigen Ansprüche, wobei das Wasserstoffgas Ethylen, Azetylen, Methan, oder eine Mischung aus diesen ist.

6. Verfahren nach einem der vorigen Ansprüche, wobei die Haftunterschicht (21) eine Schicht aus Chrom, Titan, Tantal oder Wolfram ist.

7. Verfahren nach einem der vorigen Ansprüche, wobei die Dicke der Haftunterschicht (21) zwischen 200 und 500 nm ist.

8. Verfahren nach einem der vorigen Ansprüche, wobei die Geschwindigkeit der Abscheidung der Überlagerung der Schichten (15) und/oder der Schicht des Kohlenstoffs (12) zischen 400 und 800 nm/Stunde ist.

9. Verfahren nach einem der vorigen Ansprüche, aufweisend die Anwendung einer negativen RF oder DC Pulspolarisation an dem Substrat.

10. Verfahren nach einem der vorigen Ansprüche, wobei die Abscheidung ein RF Kathodenzerstäubung ist.

11. Verfahren nach einem der vorigen Ansprüche, aufweisend einen Schritt des Detektierens des Sättigungsniveaus durch Überwachen der Abscheidungsgeschwindigkeit der aufgetragenen Schicht oder durch Beobachten der elektrischen Parameter der Magnetronquelle oderquellen.

12. Anwenden des Verfahrens nach Anspruch 1, wobei das Substrat eine Komponente einer Uhr oder ein Element eines Uhrwerks oder einer Verkleidung einer Uhr oder eine Komponente eines Lederartikels oder des Brillenhandels oder der Dekoration ist.

## Claims

1. Method of physical deposition in vapour phase to deposit a decorative and/or protective coating of deep black colour on a substrate (35), comprising:
• deposition by sputtering of an adhesion sub-layer (21) in inert atmosphere by a source or several sources of the magnetron type,
• progressive addition of an hydrocarbon gas to the inert atmosphere, according to a predetermined profile of concentration, keeping the source or the sources magnetron actives, such to obtain a superposition of layers (15) with a progressively increasing proportion of carbon above the adhesion sub-layer (21),
• increase of the partial pressure of reactive gas to a level of saturation of the target of the source or of the sources, level at which a layer (12) of amorphous carbon is deposed on the substrate (35).

2. Method according to the preceding claim, in which the same magnetron source is used to depose the adhesion sub-layer, the superposition of layers with a progressively increasing proportion of carbon, and the layer of amorphous carbon.

3. Method according to the preceding claim, in which the magnetron source has a target of a material different from carbon.

4. Method according to one of the preceding claim, including keeping the partial pressure at the saturation level, or close to the saturation level, up to the achievement of a desired coating thickness.

5. Method according to one of the preceding claims, in which the hydrocarbon gas is ethylene, acetylene, methane, or a mixture thereof.

6. Method according to one of the preceding claims, in which the adhesion sub-layer (21) is a layer of chrome, titanium, tantalum, or tungsten.

7. Method according to one of the preceding claims, in which the thickness of the adhesion sub-layer (21) is comprised between 200 and 500 nm.

8. Method according to one of the preceding claims, in which the speeds of deposition of said superposition of layers (15) and/or of said layer of carbon (12) are comprised between 400 and 800 nm/hour.

9. Method according to one of the preceding claims, comprising the application of a negative RF or DC-pulsed polarization to the substrate.

10. Method according to one of the preceding claims, in which the deposition is a RF sputtering.

11. Method according to one of the preceding claims, comprising a step of detecting the saturation level by monitoring the deposition speed of the deposited layer, or by observing electrical parameters of the source or of the sources magnetron.

12. Application of the method of claim 1, wherein the substrate (35) is a component of a watch, or an element of a movement or on external part of a watch, or a component of a leather article, or a component of a pair of spectacles, or an article of decoration.
